(19) **Europäisches Patentamt / European Patent Office / Office européen des brevets**

(11) **EP 2 645 840 B1**

(12) **EUROPEAN PATENT SPECIFICATION**

(45) Date of publication and mention
of the grant of the patent:
**17.08.2022 Bulletin 2022/33**

(21) Application number: **13161920.7**

(22) Date of filing: **02.04.2013**

(51) International Patent Classification (IPC):
**H05K 7/20** (2006.01)

(52) Cooperative Patent Classification (CPC):
**H05K 7/20909; H05K 7/20172**

(54) **Eccentric fan housing**

Exzentrisches Lüftergehäuse

Boîtier de ventilateur excentrique

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.03.2012 US 201213436551**

(43) Date of publication of application:
**02.10.2013 Bulletin 2013/40**

(73) Proprietor: **Rockwell Automation Technologies,
Inc.**
**Mayfield Heights, OH 44124 (US)**

(72) Inventors:
• **Morris, Garron Koch**
**Mequon, Wisconsin 53092 (US)**

• **Weiss, Bruce William**
**Mequon, Wisconsin 53092 (US)**
• **Michalski, Robert Michael**
**Mequon, Wisconsin 53092 (US)**

(74) Representative: **Grünecker Patent- und
Rechtsanwälte
PartG mbB
Leopoldstraße 4
80802 München (DE)**

(56) References cited:
WO-A2-2006/074447    US-A- 3 561 906
US-A1- 2005 069 410    US-A1- 2012 014 154

**Description**

**BACKGROUND**

The present disclosure relates generally to the field of power electronic devices, and particularly to a fan or blower for an air cooling system.

A wide variety of applications exist for power electronics, such as switching devices and systems. Such systems may include a thermal management system for regulating temperature of electrical equipment to improve reliability and efficiency of the electrical equipment, while reducing premature failure of the equipment. For example, the thermal management system may have a fan, blower, or other equipment for air cooling electrical equipment. In certain applications, fans or blowers may include a housing in which the fan or blower is disposed. It is now recognized that traditional blower or fan housing designs may contribute to inefficient or uneven air flow production.

US 2005/069410 A1 relates to a fan that has a volute inlet, whose shape is designed to improve the heat dissipation of the fan. The fan has a volute inlet having a reference point on the housing with respect to an outlet. The blades are partially covered by the inlet from the reference point wherein an area of the blades covered by the inlet is from a maximum to a minimum gradually in a closed loop. As a result, the set up current of air can reach a maximum prior to output from the outlet, thereby increasing the heat dissipation capability of the fan.

WO 2006/074447 A2 relates to systems for improved blower fans. In some embodiments, systems may include a casing (210) comprising an inlet (212,214) to accept a fluid and an outlet (216) to evacuate the fluid. The systems may further comprise an impeller disposed within the casing, comprising a hub (220) and one or more impeller blades (222) coupled to the hub. In some embodiments, the inlet of the casing may be shaped (218) to reduce the amount of fluid that evacuates the casing via the inlet due to pressure within the casing.

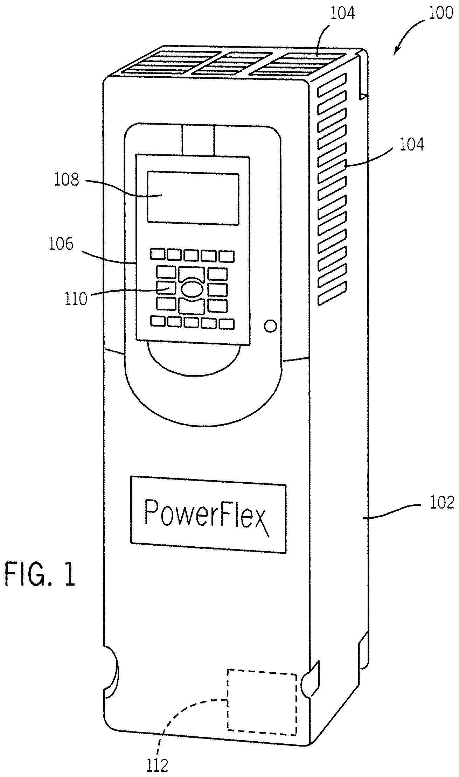

US 3 561 906 A relates to a casing for a centrifugal fan comprising a hollow box structure having square corners, one end wall having an exhaust opening at one corner and an angularly disposed shielding plate at the other corner. The fan wheel axis is offset from the center of the box toward said shielding plate. The casing is preferably formed by four uniformsized boxshaped elements which are abutted and joined as shown in Fig. 1.

**BRIEF DESCRIPTION**

It is the object of the present application to improve the efficiency of a thermal management system for an electronic component.

This object is solved by the subject matter of the independent claims.

Preferred embodiments are defined by the dependent claims.

In a first embodiment, an electrical equipment system includes an electrical equipment component, a thermal management system configured to direct air over features of the electrical equipment component, a rectangular fan housing of the thermal management system, and a fan disposed within the fan housing, wherein an axis of rotation of the fan is offset relative to a geometric center point of the rectangular fan housing.

In a second embodiment, a thermal management system configured to decrease a temperature of an electronic component during operation includes a rectangular fan housing and a fan, wherein the fan is eccentrically mounted within the rectangular fan housing.

In a third embodiment, a motor drive includes power regeneration circuitry, a rectangular housing, a fan mounted within the rectangular housing, wherein an axis of rotation of the fan is eccentric relative to a geometric center of the rectangular housing.

DRAWINGS

These and other features, aspects, and advantages of the present disclosure will become better understood when the following detailed description is read with reference to the accompanying drawings in which like characters represent like parts throughout the drawings, wherein:

FIG. 1 is a perspective view of an electronic device, which may include a blower or fan having an eccentric housing, in accordance with an embodiment of the present invention;

FIG. 2 is a schematic of an electrical equipment system, which may include a blower or fan having an eccentric housing, in accordance with an embodiment of the present invention;

FIG. 3 is a perspective view of a fan having an eccentric housing, in accordance with an embodiment of the present invention;

FIG. 4 is a perspective view of a fan having an eccentric housing, in accordance with an embodiment of the present invention;

FIG. 5 is an orthographic projection of a fan having an eccentric housing, in accordance with an embodiment of the present invention;

FIG. 6 is a perspective view of a fan and an inlet ring, in accordance with an embodiment of the present invention;

FIG. 7 is a table illustrating the effect of grid size on volumetric flow at an inlet of a fan, in accordance with an embodiment of the present invention;

FIG. 8 is graph illustrating a comparison between simulated results of a modeled fan and data provided by a manufacturer of the fan, in accordance with an embodiment of the present invention;

FIG. 9 is a table of various data points used to determine a corrected fan speed of a fan model, in accordance with an embodiment of the present invention;

FIG. 10 is a graph illustrating a comparison between fan manufacturer data and a corrected fan speed, in accordance with an embodiment of the present invention;

FIG. 11 is an orthographic projection of a parametric model of a fan having an eccentric housing, in accordance with an embodiment of the present invention;

FIG. 12 is a table having ranges of various geometric variables used for a parametric modeling of an eccentric housing, in accordance with an embodiment of the present invention;

FIG. 13 is a table listing runs or iterations computed with a computational fluid dynamics tool, in accordance with an embodiment of the present invention;

FIG. 14 is a table listing parameters derived to predict localized flow coefficients of an eccentric housing, in accordance with an embodiment of the present invention;

FIG. 15 is a table including values of various geometric variables used to define eccentric placement of a fan within a fan housing, in accordance with an embodiment of the present invention;

FIG. 16 is a schematic illustrating a flow bench for testing a fan housing, in accordance with an embodiment of the present invention;

FIG. 17 is a graph illustrating test results for a fan housing tested using the flow bench of FIG. 16, in accordance with an embodiment of the present invention;

FIG. 18 is a graph illustrating test results for a fan housing tested using the flow bench of FIG. 16, in accordance with an embodiment of the present invention;

FIG. 19 is a graph illustrating test results for a fan housing tested using the flow bench of FIG. 16, in accordance with an embodiment of the present invention;

FIG. 20 is a graph illustrating test results for a fan housing tested using the flow bench of FIG. 16, in accordance with an embodiment of the present invention;

FIG. 21 is a graph illustrating a design curve for an eccentric fan housing, in accordance with an embodiment of the present invention; and

FIG. 22 is a graph illustrating a design curve for an eccentric fan housing, in accordance with an embodiment of the present invention.

DETAILED DESCRIPTION

Embodiments of the present disclosure are directed towards a fan or blower housing with a fan disposed eccentrically within the housing. In other words, the geometric center or axis of rotation of the fan is not concentric with a geometric center of the housing. The housing has a rectangular or square configuration. Additionally, in accordance with present embodiments, the eccentric or offset placement of the fan within the housing may be uniquely customized or optimized based upon various variables such as fan size, fan capacity, housing size, operating pressure, and so forth.

FIG. 1 is a perspective view of a motor drive 100, which may include a blower or fan with an eccentric housing. In one embodiment, the motor drive 100 may be a PowerFlex drive manufactured by Rockwell Automation of Milwaukee, Wisconsin. However, it should be noted that the motor drive 100 may be representative of other electronic devices employing an air cooling system in accordance with present techniques. In the embodiment illustrated in FIG. 1, the motor drive 100 includes a housing 102 having cooling vents 104 on one or more sides of the drive 100. To facilitate interacting with the motor drive 100, the motor drive 100 may include a human-machine interface (HMI) 106. The HMI 106 may include a display 108, such as an LCD or other display and a keypad 110 allowing input by a user. Additionally, the HMI 106 may be removable and dockable in a receptacle in the housing 102.

As described further below, the motor drive 100 may include a thermal management system 112 including a blower or fan with an eccentric housing. Specifically, the blower or fan (e.g., a centrifugal fan) may be configured to provide a cooling air flow into the motor drive 100. That is, the blower or fan may force a cooling air flow across electrical equipment within the motor drive 100. For example, the motor drive 100 may include motor starters, overload relays, circuit breakers, and solid-state motor control devices, such as variable frequency drives, programmable logic controllers, power regeneration circuitry, and so forth. As will be appreciated, such electrical equipment may generate heat during operation, thereby reducing efficiency of the electrical equipment. In order to improve efficiency, the temperature of such electrical equipment may be controlled and/or lowered by the cooling air flow generated by a fan or blower.

Furthermore, as discussed in detail below, the fan or blower is disposed within an eccentric housing. In other words, the fan or blower is positioned in an offset or off-center location relative to the housing. The housing is rectangular (e.g., square) to facilitate consistent installation in electrical devices and to conserve limited available space within the electrical devices. It is now recognized that by eccentrically positioning the blower or fan within the housing, the shape and quantity of the cooling air flow exiting fan or blower is adjusted. In this manner, the efficiency of the thermal management system 112 (i.e., the fan or blower) may be improved. For example, the shape, pressure, and/or flow rate of the cooling air flow may be modified without adjusting the size of the housing. Additionally, the noise performance and energy use of the blower or fan may be improved. Moreover, in certain embodiments, the off-center or eccentric placement of the blower or fan is optimized for specific applications or operating conditions. Specifically, as discussed below, the fan or blower may be modeled using computational fluid dynamics software, and the eccentric placement of the fan or blower within the housing may be customized or calculated (e.g., using a design of experiments approach) to achieve a desired fan or blower performance.

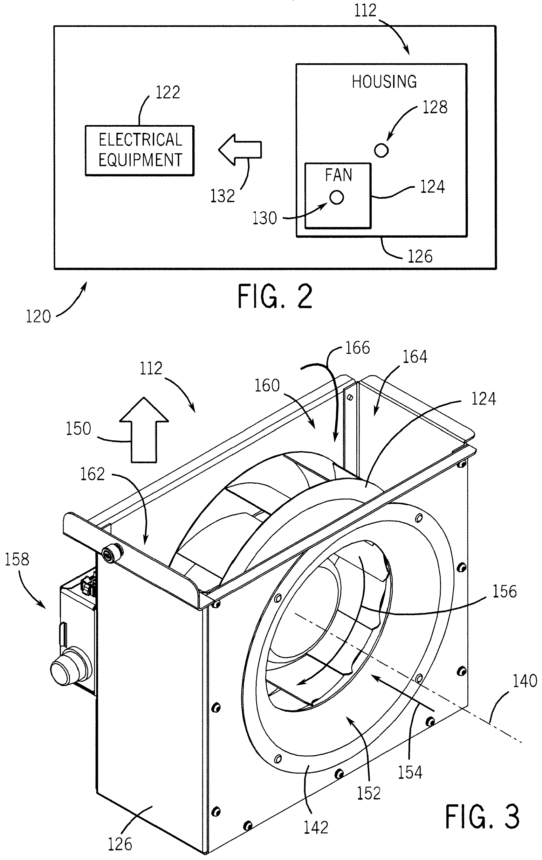

FIG. 2 is a schematic of an electrical equipment system 120 (e.g., a motor drive), which may include the thermal management system 112. While embodiments of the thermal management system 112 described above are discussed in the context of the motor drive 100, the thermal management system 112 having a fan or blower with an eccentric housing may be used in other systems having electrical equipment. Indeed, the electrical equipment system 120 illustrated in FIG. 2 may be any of a variety of systems having electrical equipment 122. For example, the electrical equipment system 120 may be a personal computer, a router or switch, a transformer, a manufacturing plant, a household appliance, an automobile, or any other system having electrical equipment 122.

As shown, the thermal management system 112 includes a fan 124 disposed within a housing 126. More specifically, as discussed in detail below, the fan 124 is disposed within the housing 126 such that the fan 124 has an eccentric, offset, or off-center placement relative to a geometric center 128 (e.g., center point) of the housing 126. That is, a geometric center 130 (e.g., center point) of the fan 124 is not concentric with the geometric center 128 of the housing 126. As shown, the thermal management system 112 generates a cooling air flow 132, which may pass towards, over, or across the electrical equipment 122, thereby reducing the temperature of the electrical equipment 122. Due to the eccentric placement of the fan 124 within the housing 126, various properties of the cooling air flow 132 may be adjusted, and efficiency of the thermal management system 112 and the electrical equipment 122 may be improved, as discussed below.

FIG. 3 is a perspective view of the thermal management system 112, illustrating the fan 124 disposed eccentrically within the housing 126. That is, the geometric center 130 of the fan 124 (e.g., an axis of rotation 140 of the fan 124) is not concentric with the geometric center 128 of the housing 126. In the illustrated embodiment, the housing 126, which may be formed from sheet metal or other material, has a rectangular configuration. That is, front and rear faces of the housing 126 are substantially rectangular. For example, the housing 126 may have a rectangular prism configuration, and/or an interior of the housing 126 may have a substantially cubic volume. However, other embodiments of the housing 126 may have other configurations. As shown, the fan 124 in the illustrated embodiment is mounted within the housing 126 with an inlet ring 142 and is configured to generate an air flow 150, which exits the housing 126 at an approximately 90 degree angle relative to an air inlet 152 of the fan 124. More particularly, air 154 enters the housing 126 through the air inlet 152, and the fan 124, which is driven in a clockwise direction 156 by a motor 158, generates the air flow 150, which exits through an open top 160 of the housing 126. Due to the eccentric mounting of the fan 124 within the housing 126, a high pressure zone 162 within the housing 126 is larger than a low pressure zone 164 within the housing. Due to this arrangement, the flow rate of the air flow 150 of the fan 124 and the housing 126 is improved, thereby improving the efficiency of the fan 124 and the housing 126. Additionally, the decrease in size of the low pressure zone 164 helps reduce portions of the air flow 150, represented by arrow 166, from re-entering the housing 126.

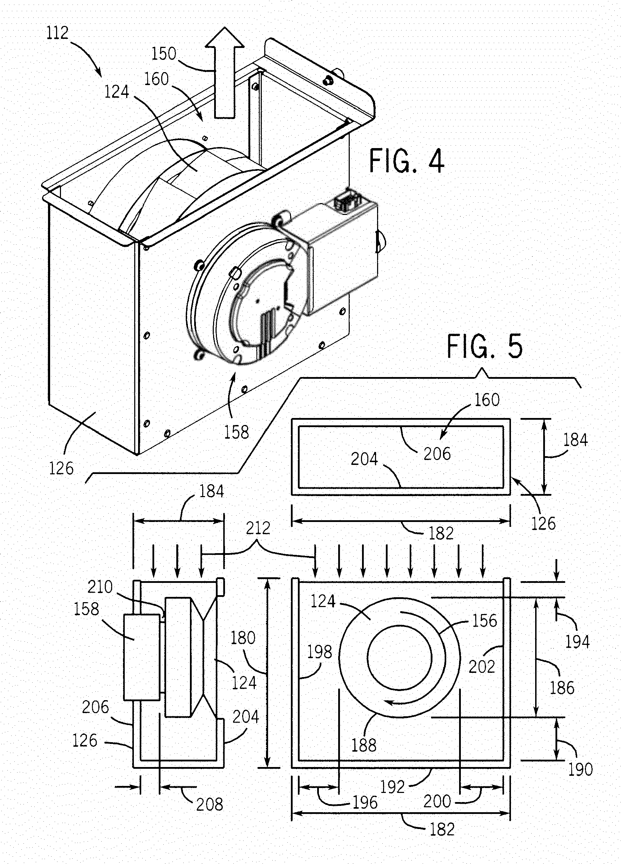

FIG. 4 is a perspective view of the thermal management system 112, illustrating the fan 124 disposed eccentrically within the housing 126. More particularly, FIG. 4 provides a perspective view of the thermal management system 112 with the motor 158 positioned in front. As a result, FIG. 4 clearly illustrates that the motor 158 is also disposed eccentrically with respect to the housing 126. In other words, a geometric center or axis of rotation of the motor 158 is offset from the geometric center 128 of the housing 126. In certain embodiments, the motor 158 may be an electric motor, such as a brushless DC motor, however, other types of motors 158 may be used to power the fan 124.

FIG. 5 is an orthographic projection of the fan 124 disposed eccentrically within the housing 126. In the illustrated embodiment, the housing 126 has a rectangular configuration. More specifically, the illustrated housing 126 has a height 180, a length 182, and a depth 184. Additionally, the fan 124 has a diameter 186. For example, the diameter 186 may be approximately 100 to 500 mm, 150 to 450 mm, 200 to 400 mm, or 250 to 350 mm. As mentioned above, the fan 124 has an offset or off-center placement within the housing 126. That is, while the fan 124 itself is generally uniform in shape, the geometric center 130 of the fan 124 is not concentric with the geometric center 128 of the housing 126.

As mentioned above, the eccentricity of the fan 124 within the housing 126 may be described with reference to various geometric variables. For example, the location of the fan 124 within the housing 126 may be described with respect to various distances from the fan 124 to the housing 126. As shown, an outer circumference 188 of the fan 124 is approximately a distance 190 from a base 192 of the housing 126. That is, the fan 124 is positioned the distance 190 above the base 192 of the housing 126. Consequently, the outer circumference 188 of the fan 124 is located a distance 194 from the top 160 of the housing 126. Similarly, the outer circumference 188 of the fan 124 is positioned a distance 196 from a left wall 198 of the housing 126 and a distance 200 from a right wall of the housing 126. As will be appreciated, the distances 196 and 200 may not be equal, thereby positioning the fan 124 in an off-center or offset location relative to the housing 126. As a result, the distances 190, 194, 196, and 200 may be used to define the position of the fan 124 within the housing 126, at least with respect to a front face 204 and a rear face 206 of the housing 126. Additionally, the position of the fan 124 within the housing 126 may be at least partially expressed in terms of a distance 208 the motor 158 is positioned from the rear face 206 of the housing 126. That is, the distance 208 is the distance from a front facing surface 210 of the motor to the housing wall forming the rear face 206 (i.e., the face opposite the front face 204 or air inlet 152).

As mentioned above, in accordance with present embodiments, the discussed geometric variables (e.g., the distances 190, 196, 200, and 208) may be customized or optimized to achieve desired or target characteristics of the air flow 150 generated by the fan 124 and the housing 126. For example, the geometric variables discussed above may be optimized based upon factors such as a size or capacity of the fan 124 and/or size constraints of the housing 126 (e.g., the height 180, the length 182, and the depth 184 of the housing 126). For example, in certain embodiments, a ratio of the distance 196 to the diameter 186 of the fan 124 may be approximately 0.10 to 0.30. Similarly, a ratio of the distance 190 to the diameter 186 of the fan 124 may be approximately 0.05 to 0.30. Additionally, in some embodiments, a ratio of the distance 200 to the diameter 186 of the fan 124 may be approximately 0.05 to 0.20. For further example, a ratio of the distance 196 to the distance 190 may be approximately 2.50 to 0.50. According to the claimed invention a ratio of the distance 196 to the distance 200 is 2.50 to 1.50, and a ratio of the distance 190 to the distance 200 may be approximately 0.50 to 2.00. As discussed in detail below, the geometric variables may be optimized using parametric modeling (e.g., modeling of the fan 124 and/or the housing 126) and statistical methods to achieve an improved air flow 150.

Additionally, as discussed below, other variables may be considered when optimizing the eccentric position of the fan 124 within the housing 126. For example, an ambient or operating pressure of the environment having the housing 126 and fan 124, indicated by arrows 212, may be considered in optimizing the eccentricity of the fan 124 within the housing 126. The experimental data reproduced below indicates that the eccentric positioning of the fan 124 within the housing 126 may contribute to improved flow rates, pressure, efficiencies, and so forth, of the air flow 150. The improved air flow 150 may then enable improved cooling of electrical equipment 122 within the electrical equipment system 120 (e.g., the motor drive 100), thereby improving performance and efficiency of the electrical equipment system 120.

The discussion below describes a method which may be used for optimizing the various geometric variables of the housing 126 to achieve improved efficiency of the fan 124 over an expected operating pressure range (e.g., operating pressure 212). More specifically, the experiments below utilize Design of Experiments techniques, computational fluid dynamic tools, and genetic algorithmbased optimization tools to develop efficient fan housing 126 designs.

The numerical and experimental results are shown in terms of dimensionless flow ($\varphi$), pressure ($\psi$), and power ($\eta$) fan coefficients, which may defined as:

$$\phi = \frac{Q}{\omega \cdot D^3} \qquad (1)$$

$$\Psi = \frac{P}{\rho \cdot \omega^2 \cdot D^2} \qquad (2)$$

$$\eta = \phi \cdot \Psi \qquad (3)$$

where Q represents volumetric flow, $\omega$ represents rotational speed of the fan 124, P represents pressure, p represents density of air, and D represents the diameter 186 of the fan 124.

The computational fluid dynamics (CFD) software used in the present experiments was ANSYS Icepak 13. ANSYS Icepak 13 has built-in objects that represent simplified impellers and centrifugal fans (e.g., fan 124). These built-in objects may be used to simulate flow in various applications. Additionally, a Moving Reference Frame (MRF) technique was used to account for effects of blade geometry and swirl.

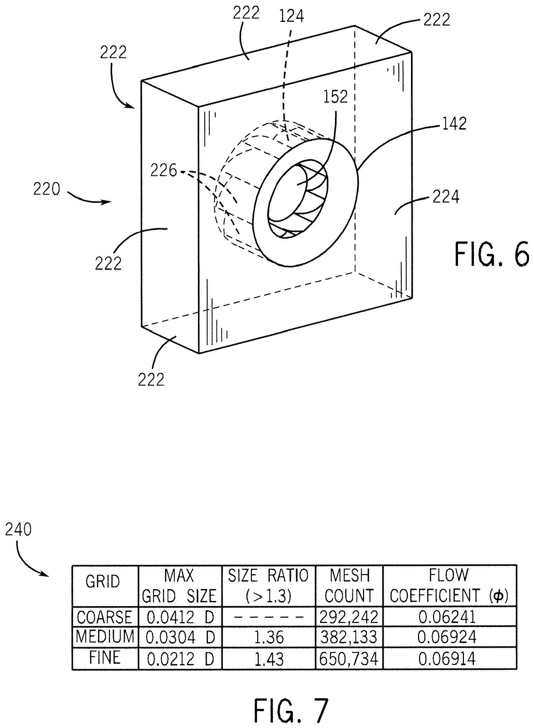

Before optimizing the housing 126, performance of the fan 124 without the housing 126 was calculated and verified. Specifically, detailed CAD models of the fan 124 and the inlet ring 142 provided by the fan 124 manufacturer were imported into ANSYS IcePro 5.1 and processed into geometric entities that could be imported into ANSYS Icepak 13. FIG. 6 is a perspective view of the fan 124 and the inlet ring 142 imported into ANYSS Icepak 13. Specifically, the models of the fan 124 and the inlet ring 142 were placed in a box 220 where the boundaries were located one diameter from the fan 124. As shown, all sides 222 of the box 220, except for an inlet side 224 were open. In this way, the performance of the fan 124 without the housing 126 could be simulated. The MRF fluid cylinder was defined to be 2% larger than the diameter 186 of the fan 124, so as to enclose the entire moving portion of the fan 124. Additionally, the operational fan 124 speed was assigned to the MRF fluid region.

A multi-level meshing technique was used along with an automated hexdominated mesher to capture detailed interactions between blades 226 of the fan 124 and the MRF fluid. The blade 226 geometry was assigned a value of two, while the remaining geometry was assigned a value of one. The model was run at a temperature of 20°C and an air density of 1.2 kg/m$^3$ using first-order discretization methods for continuity, momentum, and turbulence equations. Model convergence was achieved when the maximum normalized residual was less than $1 \times 10^{-4}$.

Furthermore, grid independence studies were performed using a grid convergence index method with a pressure coefficient ($\psi$) of 0.058 applied on all sides 222 except for the inlet side 224 shown in FIG. 6. FIG. 7 is a table 240 illustrating the effect of grid size on volumetric flow at the inlet 152 of the fan 124 with the normalized pressure coefficient ($\psi$) of 0.058. Specifically, FIG. 7 includes maximum grid size, size ration, mesh count, and flow coefficient ($\varphi$) for coarse, medium, and fine grids. The grid convergence index was calculated to be 0.011% for the flow coefficient ($\varphi$) at the inlet 152 of the fan 124. For the simulations discussed below, the finest grid (e.g., "Fine", shown in table 240) was used.

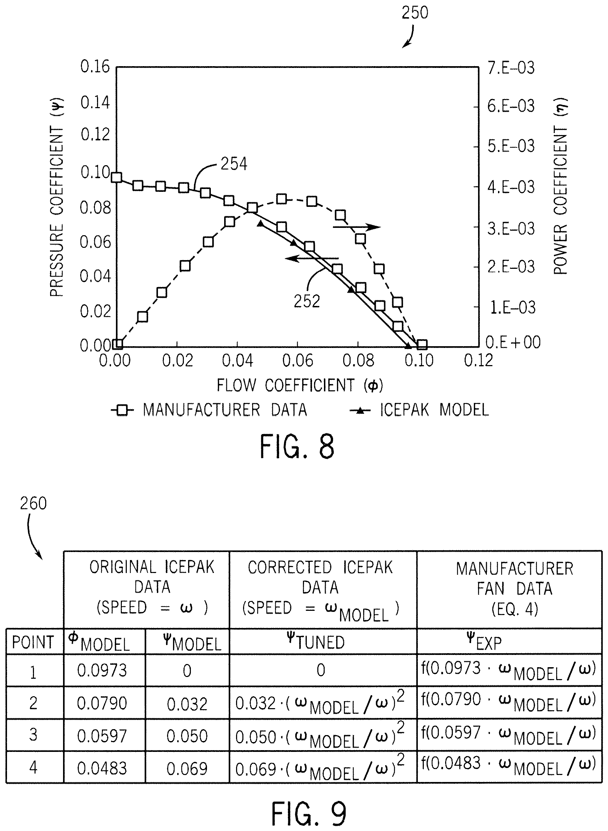

A fan 124 performance curve was extracted by applying pressure coefficient ($\psi$) boundary conditions of 0, 0.032, 0.053, and 0.069 to the open sides 222 of the model of the housing 126. As will be appreciated, the above pressure coefficient ($\psi$) boundary conditions may cover the most efficient range of the fan 124. FIG. 8 is a graph 250 illustrating a comparison between the Icepak MRF simulation results of the fan 124, indicated by reference numeral 252, and fan 124 data provided by the fan 124 manufacturer, indicated by reference numeral 254. As shown, the fan 124 performance predicted by the Icepak MRF simulation (e.g., line 252) followed, but consistently under-predicted, the performance measured by the manufacturer (e.g., lines 254).

To account for the discrepancy between predicted and measured performance discussed above, the model of the fan 124 was tuned. Specifically, FIG. 9 is a table 260 of various data points used to determine a corrected fan speed of the fan 124 model. The approach used to tune the model of the fan 124 was to adjust the fan 124 speed used in the model (e.g., $\omega_{model}$) to minimize the error between the predicted fan 124 curve (e.g., line 252 in the graph 250 of FIG. 8) and the manufacturer's data curve (e.g., line 254 in the graph 250 of FIG. 8). First, the dimensionless manufacturer fan 124 experimental performance data was fit to the following quadratic equation with a correlation coefficient (R-squared) of 99.91%:

$$\Psi_{exp} = 9.35 \times 10^{-2} + 8.06 \times 10^{-2} \cdot \phi - 9.97 \cdot \phi^2 \qquad (4)$$

where $\psi_{exp}$ is the pressure coefficient and $\varphi$ is the flow coefficient. Fan Laws (e.g., Eqs. (5) and (6) below) for volumetric flow and pressure were used to adjust the Icepak results.

$$\phi_2 = \phi_1 \cdot \left(\frac{\omega_{model}}{\omega}\right) \qquad (5)$$

$$\Psi_2 = \Psi_1 \cdot \left(\frac{\omega_{model}}{\omega}\right)^2 \qquad (6)$$

Thereafter, the expected fan 124 pressure for teach data point at the same corrected Icepak volumetric flow was calculated using Eqn. (4) above. Then, the corrected model fan speed $\omega_{model}$ for the Icepak fan 124 model was determined by using a gradient-based optimizer to minimize the Sum of Squared Errors (SSE) between the tuned Icepak model pressure coefficient $\varphi_{tuned}$ and the expected normalized pressure coefficient $\psi_{exp}$. This determination was made using the following equation:

$$SSE = \sum_{i=1}^{4}\left(\Psi_{tuned,i} - \Psi_{exp,i}\right)^2 \qquad (7)$$

The tuned fan speed $\omega_{model}$ for the Icepak model was found to be 2.4% higher than the actual operating speed.

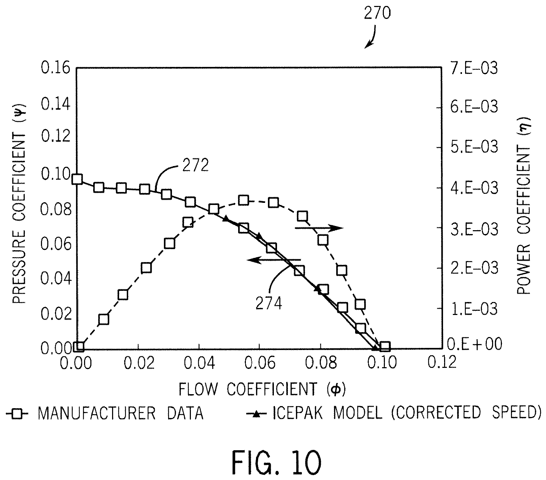

FIG. 10 shows a graph 270 illustrating a comparison between the manufacturer data, indicated by reference numeral 272, and the corrected or tuned fan speed, indicated by reference numeral 274. More specifically, over the pressure coefficient range of 0.032 to 0.069, the graph 270 shows that the manufacturer data (e.g., line 272) and the corrected model fan speed (e.g., line 274) are in agreement. In other words, the fan 124 performance predicted by the Icepak model approximately matches the manufacturer data after a 2.4% speed increase in the Icepak model.

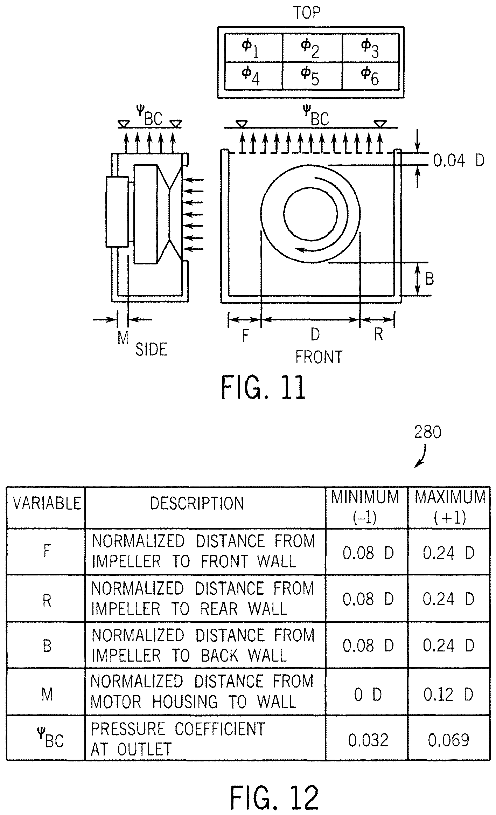

As mentioned above, certain disclosed embodiments are directed towards fan housings 126 with rectangular or square configurations or shapes. Additionally, certain embodiments of the housing 126 output an air flow (e.g., air flow 150) at essentially a 90 degree angle from a central axis of an inlet (e.g., inlet 152) of the housing 126. In other words, air enters the fan 124 on one side (e.g., inlet side 224) and exits on a side 90 degrees from the inlet. Additionally, as discussed above, the eccentric placement of the fan 124 within the housing 126 may be defined with respect to various geometric variables. For example, FIG. 11 is an orthographic projection of a parametric model of the housing 126, illustrating various input factors (e.g., geometric variables) that define the eccentricity of the fan 124. As will be appreciated, the orthographic projection shown in FIG. 11 is similar to the orthographic projection shown in FIG. 5. However, for purposes of clarity, the orthographic projection shown in FIG. 11 includes the experimental variables used in the discussion below.

The four geometric variables that were selected for the rectangular fan housing 126 that defined the eccentric placement of the fan having a diameter D within the housing 126 were each of the distances from the front (F), bottom (B), and rear (R) walls to the fan 124 and the distance (M) from the motor (e.g., motor 158) to the wall opposite the fan inlet (e.g., inlet 152). A fifth variable, the pressure coefficient applied at the blower housing outlet ($\psi_{BC}$), was selected so that the fan performance curve could be extracted over the expected pressure coefficient operating region of 0.032 and 0.069. Furthermore, as shown in FIG. 11, the outlet (e.g., top 160) of the fan 124 and housing 126 was also discretized into 6 areas so that localized volumetric coefficients ($\varphi_{x=1-6}$) could be extracted. FIG. 12 illustrates a table 280 which includes ranges, expressed in terms of the diameter D of the fan 124, of the input factors (e.g., geometric variables) used for the parametric modeling of the fan housing 126. Specifically, FIG. 12 includes minimum and maximum values for variables F, R, B, M, and $\psi$, which are all illustrated in FIG. 11 and described in table 280.

As will be appreciated, Design of Experiments (DoE) is a statistical method where a set of input factors (Xs) are varied in a controlled manner in order to measure their effects on one or more response variables (Ys). The advantage of using a DoE approach is that the relationships among the input factors and response variables can be extracted in a fewer number of experiments. Additionally, the relationships among the input factors and response variables may be expressed in an empirical model that contains first-order and second-order terms.

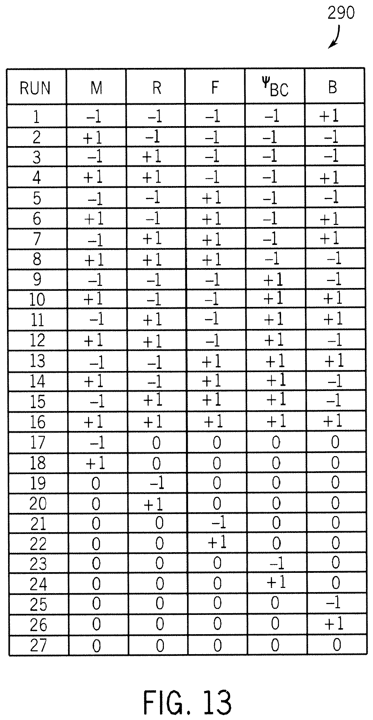

For the experiments discussed herein, a five-factor, 2-level, half-factorial design was used. This design required multiple runs or iterations in Icepak, which are listed in table 290 shown in FIG. 13. In table 290, the -1 value indicates the minimum value and the +1 value indicates the maximum value for each variable listed in table 280 of FIG. 12. The flow coefficient responses were expected to have strong second-order effects, so additional face-centered points (e.g., runs 17-26 in table 290) were added, as well as a center point (e.g., run 27 in table 290). Furthermore, in table 290, a value of zero indicates a mid-point value between the minimum (-1) and maximum (+1) values listed in table 280.

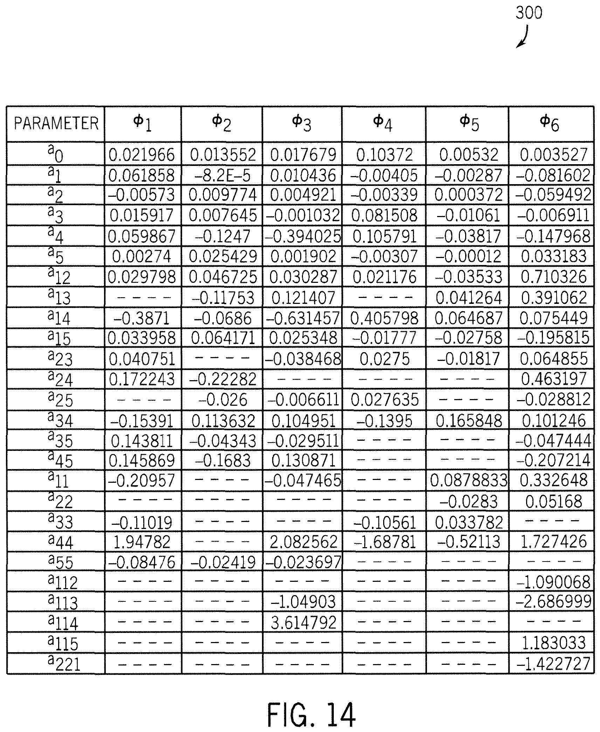

The 27 runs listed in table 290 were performed in Icepak, and the flow coefficients ($\varphi_{x=1-6}$) for each of the six discretized sections at the outlet of the housing 126 (shown in FIG. 11) were fit to polynomial equations that contained linear, two-way interactions, and quadratic terms for the input factors M, R, F, $\psi_{BC}$, and B. The model parameters ($a_n$) in Eqn. (8) below were calculated using a backward linear regression algorithm where a term was removed if the t-statistic for that term was greater than 0.05 (indicating that there is a 95% probability that the term is zero). The backward regression algorithm starts with removing any insignificant second-order terms, followed by a two-way interaction, and linear terms. Model hierarchy was maintained so that no insignificant linear terms were removed if they were used in two-way interaction or second order terms. FIG. 14 is a table 300 which lists the parameters derived using Eqn. (8) to predict the localized flow coefficients ($\varphi_{x=1-6}$) at the outlet (e.g., at the top 160) of the housing 126.

$$[\phi_1, \phi_2, \phi_3, \phi_3, \phi_4, \phi_5, \phi_6] = a_0 + a_1 \cdot M + a_2 \cdot R + a_3 \cdot F + a_4 \cdot \Psi_{BC} + a_5 \cdot B +$$
$$a_{12} \cdot M \cdot R + a_{13} \cdot M \cdot F + a_{14} \cdot M \cdot \Psi_{BC} + a_{15} \cdot M \cdot B + a_{23} \cdot R \cdot F + a_{24} \cdot R \cdot \Psi_{BC} +$$
$$a_{25} \cdot R \cdot B + a_{34} \cdot F \cdot \Psi_{BC} + a_{35} \cdot F \cdot B + a_{45} \cdot \Psi_{BC} \cdot B + a_{11} \cdot M^2 + a_{22} \cdot R^2 + a_{33} \cdot$$
$$F^2 + a_{44} \cdot \Psi_{BC}2 + a_{55} \cdot B^2 + a_{112} \cdot M^2 \cdot R + a_{113} \cdot M^2 \cdot F + a_{114} \cdot M^2 \cdot \Psi_{BC} +$$
$$a_{115} \cdot M^2 \cdot \Psi_{BC} + a_{115} \cdot M^2 \cdot B + a_{221} \cdot R^2 \cdot M$$

$$(8)$$

For the experiments discussed herein, two housing 126 designs were created through various combinations of the flow and power coefficients listed in table 300 shown in FIG. 14. Because the operating point was unknown at the time of the housing 126 design, optimization was performed by setting the pressure coefficient fixed at 0.032, 0.050, and 0.069. This produced three sets of power coefficient equations that could be combined into composite objective functions.

The first housing 126 design attempted to maximize the power coefficient over the expected pressure coefficient range of 0.032 to 0.069. The objective function used was:

$$MAXIMIZE\left(Average\left(\eta_{\phi=0.032}, \eta_{\phi=0.050}, \eta_{\phi=0.069}\right)\right)$$

$$\eta = \left(\phi_1 + \phi_2 + \phi_3 + \phi_4 + \phi_5 + \phi_6\right) \cdot \Psi_{BC} \qquad (9)$$

For the objective function shown in Eqn. (9), the following geometric constraints were applied:

$$\frac{F+R}{D} \leq 0.248$$

$$M = 0 \qquad (10)$$

$$\frac{B}{D} \leq 0.08$$

The size constraints were put in place to minimize the size of the housing 126 to fit in a particular model ("Design 1") of drive (e.g., motor drive 100). A second housing 126 design ("Design 2") also attempted to maximize the power coefficient using Eqn. (9), but used the following geometric constraints to limit the housing size 126 for a different drive (e.g., motor drive 100).

$$\frac{F+R}{D} \le 0.368$$

$$\frac{M}{D} \le 0.115 \qquad\qquad (11)$$

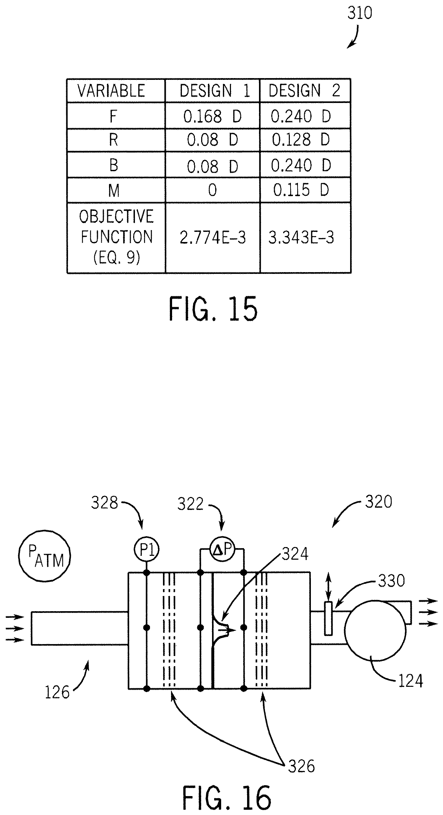

The genetic algorithm was run with a population of 200 individuals until there was no change in objective function for at least 20 generations. As shown in a table 310 in FIG. 15, the average power coefficient for Design 1 is 17% lower than the average power coefficient for Design 2, due to more stringent geometric constraints which limit the flow (e.g., air flow 150). Furthermore, the table 300 includes values, expressed in terms of the diameter D of the fan 124, of the various geometric variables used to define the eccentric placement of the fan 124 within the housing 126.

FIG. 16 is a schematic illustrating a flow bench 320 that was designed and built to allow for testing the housing 126 according to ANSI/AMCA 210-07 standards. Specifically, the flow bench 320 was capable of measuring volumetric flow rates up to 1100 ft$^3$/min and pressure up to 3 inches of water. The volumetric flow through the tested device (e.g., the housing 126) was obtained by first measuring a pressure drop 322 across precision flow nozzles 324 installed in parallel. For example, the precision nozzles 324 may be 1, 2, 3, or 4 inch flow nozzles 324, and the flow nozzles 324 may be manufactured to the AMCA 210-07 standard.

Settling screens 326 upstream and downstream of the flow nozzles 324 were incorporated to smooth out the flow field. A static pressure for the housing 126 was measured using a manometer 328, with one end open to atmosphere. The pressure measurements were obtained by average four pressure taps located 90 degrees apart, perpendicular to the flow direction. Fan performance curves, discussed below, were obtained by adjusting the flow rate with an adjustable blast gate 330 while holding the flow bench blower (e.g., fan 124) constant.

Three samples of each of Design 1 of the housing 126 and Design 2 of the housing 126 were constructed from sheet metal and measured on the flow bench 320 depicted in FIG. 16. To capture the full range of flow, 1, 2, 3, and 4 inch flow nozzles 324 were used in combination. Additionally, an uncertainty analysis for the combined four nozzles 324 was found to be +/- 2.0% for the volumetric flow rate measurement and +/- 3.3% for static pressure measurement. The experimental results of this procedure are shown below.

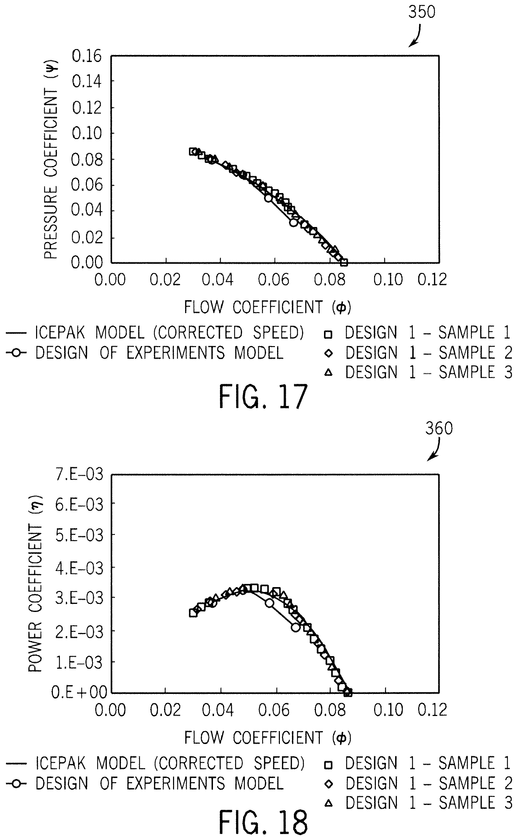

FIGS. 17-20 are graphs illustrating the results of the experiments described above. That is, the graphs in FIGS. 17-20 show the housing 126 performance on the flow bench 320 for Designs 1 and 2 of the housing 126 described above. For example, FIG. 17 is a graph 350 of the flow bench 320 test results for the first, second, and third samples of Design 1 of the housing 126. Specifically, the graph 350 shows flow and pressure coefficient performance for Design 1 of the housing 126 as predicted by Icepak and the Design of Experiments calculations compared to the measured performance (e.g., using the flow bench 320) for the three samples of Design 1 of the housing 126. Although the Design of Experiments model predicted the flow coefficient with a maximum error of 4.3%, it did not completely capture the curvature. The Icepak model that was run for Design 1 of the housing 126 correctly predicted the flow coefficients and agreed with the measured samples with a maximum error of 1.6%.

Similarly, FIG. 18 is a graph 360 of the flow bench 320 test results for the first, second, and third samples of Design 1 of the housing 126, illustrating power coefficient performance (e.g., calculated from flow and pressure measurements) for Design 1 of the fan housing 126 compared with the performance predicted by Icepak and the Design of Experiments calculations. As shown, the Design of Experiments predicted the power coefficient with a maximum error of 6.3% over the pressure coefficient range of 0.032 to 0.069, and the Icepak model predicted the power coefficient with a maximum error of 3.8%. As with FIG. 17, the Icepak model accurately captured the power coefficient behavior as it varied with flow coefficient.

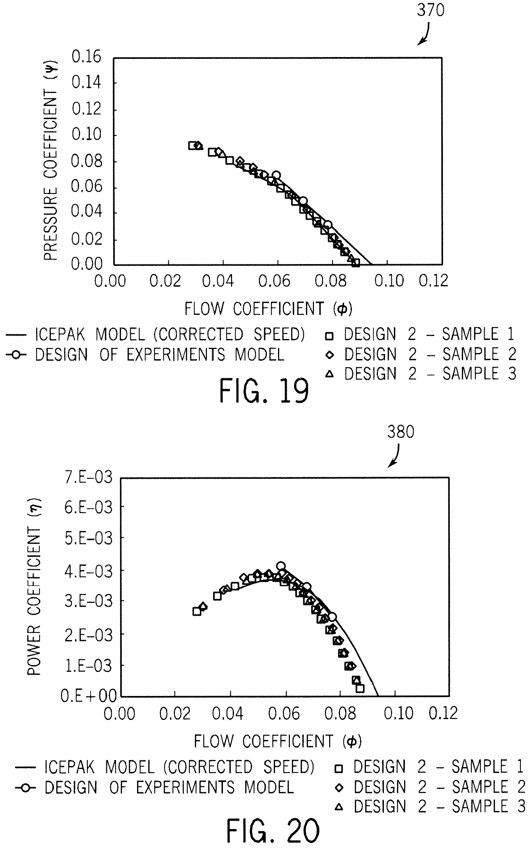

FIG. 19 is a graph 370 of the flow bench 320 test results for the first, second, and third samples of Design 2 of the housing 126. The graph 370 shows flow and pressure coefficient performance for Design 2 of the housing 126 as predicted by Icepak and the Design of Experiments calculations compared to the measured performance (e.g., using the flow bench 320) for the three samples of Design 2 of the housing 126. The Design of Experiments model predicted the flow coefficient with a maximum error of 6.0%. The maximum error for the Icepack prediction for the flow coefficient was 7.1%.

Lastly, FIG. 20 is a graph 380 of the flow bench 320 test results for the first, second, and third samples of Design 2 of the housing 126, illustrating power coefficient performance (e.g., calculated from flow and pressure measurements) for Design 2 of the fan housing 126 compared with the performance predicted by Icepak and the Design of Experiments calculations. As shown, the Design of Experiments model predicted the power coefficient with a maximum error of 3.5% over the pressure coefficient range of 0.032 to 0.069, while the Icepak prediction for power coefficient has a maximum error of 5.6%.

As will be appreciated, one advantage of having performed a Design of Experiments study on the housing 126 design is that the flow, pressure, and power coefficient behavior may be captured over a wide geometry for the housing 126 and pressure coefficient range for the fan 124. Design curves were generated for flow and power coefficients for M = 0 as a function of the effective diameter ($d_n$) of the housing 126, which may defined as:

$$d_h = \frac{2 \cdot H \cdot W}{H + W} \qquad (12)$$

where $H$ is the height of the housing 126 and $W$ is the width of the housing 126, with $H$ and $W$ defined as:

$$H = 0.04 \cdot D + D + B \qquad (13)$$

$$W = F + D + R \qquad (14)$$

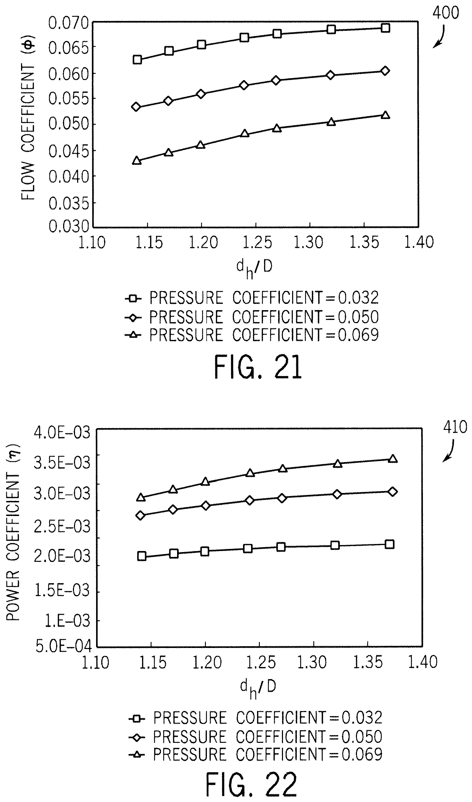

FIGS. 21 and 22 illustrate the design curves generated using the process described above. Specifically, FIG. 21 shows a graph 400 of the flow coefficient as a function of a non-dimensional housing 126 diameter $d_h$/D and pressure coefficient for M=0, and FIG. 22 shows a graph 410 of the power coefficient as a function of a non-dimensional housing 126 diameter $d_h$/D and pressure coefficient for M=0. The curves in graphs 400 and 410 can be used to help understand housing 126 geometric effects on fan 124 performance. For example, the power coefficient curves in graph 410 indicate the $d_h$/D ratio has a greater effect on power coefficient as the pressure coefficient value increases.

Embodiments of the present disclosure are directed towards a fan or blower housing with a fan disposed eccentrically within the housing. Indeed, the geometric center or axis of rotation of the symmetrical fan is not concentric with a geometric center of the housing. The housing has a rectangular or square configuration. Additionally, the eccentric or offset placement of the fan within the housing may be customized or optimized based upon variables such as fan size, fan capacity, housing size, operating pressure, and so forth.

The claimed invention is defined by the appended claims.

## Claims

1.  An electrical equipment system (120), comprising:

    an electrical equipment component (122);

    a thermal management system (112) configured to direct air over features of the electrical equipment component (122);
    a rectangular fan housing (126) of the thermal management system (112); and

    a centrifugal fan (124) disposed within the fan housing (126), wherein an axis of rotation (140) of the centrifugal fan (124) is offset relative to a geometric center point (130) of the rectangular fan housing (126), wherein said offset of the centrifugal fan (124) within the rectangular fan housing (126) is optimized such that a high pressure zone (162) between a first wall (198) and an outer circumference (188) of the centrifugal fan (124) disposed a first distance (196) from said first wall (198) of the rectangular fan housing (126) is larger than a low pressure zone (164) between a second wall (202) and the outer circumference (188) of the centrifugal fan (124) disposed a second distance (200) from said second wall (202) of the rectangular fan housing (126), wherein the first wall (198) is opposite the second wall (202) and wherein a ratio of the first distance (196) to the second distance (200) is 2.50 to 1.50.

2.  The electrical equipment system (120) of claim 1, wherein the electrical equipment component (122) is a motor drive (100).

3.  The electrical equipment system (120) of claim 2, wherein the motor drive (100) comprises power regeneration circuitry.

4.  The electrical equipment system (120) of anyone of claims 1 to 3, wherein the rectangular fan housing (126) comprises a square fan housing (126), or
    wherein the rectangular fan housing (126) comprises one or more sheet metal sides (222).

5. The electrical equipment system (120) of anyone of claims 1 to 4, wherein the rectangular fan housing (126) and the centrifugal fan (124) are configured to receive an input air flow (154), and the centrifugal fan (124) is configured to generate an output air flow (150), wherein the output air flow (150) exits the rectangular fan housing (126) at an 90 degree angle relative to the input air flow (154)

6. The electrical equipment system (120) of anyone of claims 1 to 5, wherein a ratio of the first distance (196) to a diameter (186) of the centrifugal fan (124) is 0.10 to 0.30, or
wherein a ratio of the second distance (200) to a diameter (186) of the centrifugal fan (124) is 0.05 to 0.20.

7. The electrical equipment system (120) of claim 1, wherein the outer circumference (188) of the centrifugal fan (124) is disposed a first distance (190) from a base wall (192) of the rectangular fan housing (126), and the outer circumference (188) is disposed a second distance (194) from a top opening (160) of the rectangular fan housing (126), wherein an output air flow (150) generated by the centrifugal fan (124) is configured to exit the top opening (160), the base wall (192) is opposite the top opening (160), and the first distance (190) and the second distance (194) are different.

8. The electrical equipment system (120) of claim 7, wherein a ratio of the first distance (190) to a diameter (186) of the centrifugal fan (124) is 0.05 to 0.30

**Patentansprüche**

1. Elektrisches Ausrüstungs-System (120), das umfasst:

   eine elektrische Ausrüstungs-Komponente (122);

   ein Wärmemanagement-System (112), das so ausgeführt ist, dass es Luft über Strukturen der elektrischen Ausrüstungs-Komponente (122) leitet;
   ein rechteckiges Lüftergehäuse (126) des Wärmemanagement-Systems (112); sowie

   einen Zentrifugallüfter (124), der in dem Lüftergehäuse (126) angeordnet ist, wobei eine Drehachse (140) des Zentrifugallüfters (124) relativ zu einem geometrischen Mittelpunkt (130) des rechteckigen Lüftergehäuses (126) versetzt ist, der Versatz des Zentrifugallüfters (124) innerhalb des rechteckigen Lüftergehäuses (126) so optimiert ist, dass eine Hochdruckzone (162) zwischen einer ersten Wand (198) und einem Außenumfang (188) des Zentrifugallüfters (124), die in einem ersten Abstand (196) zu der ersten Wand (198) des rechteckigen Lüftergehäuses (126) angeordnet ist, größer ist als eine Niederdruckzone (164) zwischen einer zweiten Wand (202) und dem Außenumfang (188) des Zentrifugallüfters (124), die in einem zweiten Abstand (200) zu der zweiten Wand (202) des rechteckigen Lüftergehäuses (126) angeordnet ist, wobei die erste Wand (198) der zweiten Wand (202) gegenüberliegt und ein Verhältnis des ersten Abstandes (196) zu dem zweiten Abstand (200) 2,50 bis 1,50 beträgt.

2. Elektrisches Ausrüstungs-System (120) nach Anspruch 1, wobei die elektrische Ausrüstungs-Komponente (122) ein Motorantrieb (100) ist.

3. Elektrisches Ausrüstungs-System (120) nach Anspruch 2, wobei der Motorantrieb (100) Schaltungstechnik für Energierückgewinnung umfasst.

4. Elektrisches Ausrüstungs-System (120) nach einem der Ansprüche 1 bis 3, wobei das rechteckige Lüftergehäuse (126) ein quadratisches Lüftergehäuse (126) umfasst oder das rechteckige Lüftergehäuse (126) eine oder mehrere Blechseite/n (222) umfasst.

5. Elektrisches Ausrüstungs-System (120) nach einem der Ansprüche 1 bis 4, wobei das rechteckige Lüftergehäuse (126) und der Zentrifugallüfter (124) so ausgeführt sind, dass sie einen Eingangs-Luftstrom (154) empfangen, und der Zentrifugallüfter (124) so ausgeführt ist, dass er einen Ausgangs-Luftstrom (150) erzeugt,
und der Ausgangs-Luftstrom (150) aus dem rechteckigen Lüftergehäuse (126) in einem 90°-Winkel relativ zu dem Eingangs-Luftstrom (154) austritt.

6. Elektrisches Ausrüstungs-System (120) nach einem der Ansprüche 1 bis 5, wobei ein Verhältnis des ersten Abstandes (196) zu einem Durchmesser (186) des Zentrifugallüfters (124) 0,10 bis 0,30 beträgt,
oder
ein Verhältnis des zweiten Abstandes (200) zu einem Durchmesser (186) des Zentrifugallüfters (124) 0,05 bis 0,20 beträgt.

7. Elektrisches Ausrüstungs-System (120) nach Anspruch 1, wobei der Außenumfang (188) des Zentrifugallüfters (124) in einem ersten Abstand (190) zu einer Bodenwand (192) des rechteckigen Lüftergehäuses (126) angeordnet ist und der Außenumfang (188) in einem zweiten Abstand (194) zu einer oberen Öffnung (160) des rechteckigen Lüftergehäuses (126) angeordnet ist, ein durch den Zentrifugallüfter (124) erzeugter Ausgangs-Luftstrom (150) so ausgeführt ist, dass er über die obere Öffnung (160) austritt, die Bodenwand (192) der oberen Öffnung (160) gegenüberliegt und der erste Abstand (190) und der zweite Abstand (194) verschieden sind.

8. Elektrisches Ausrüstungs-System (120) nach Anspruch 7, wobei ein Verhältnis des ersten Abstandes (190) zu einem Durchmesser (186) des Zentrifugallüfters (124) 0,05 bis 0,30 beträgt.

**Revendications**

1. Système d'équipement électrique (120), comprenant :

   un composant d'équipement électrique (122) ;

   un système de gestion thermique (112) configuré pour diriger l'air sur des éléments du composant d'équipement électrique (122) ;
   un boîtier de ventilateur rectangulaire (126) du système de gestion thermique (112) ; et

   un ventilateur centrifuge (124) disposé à l'intérieur du boîtier de ventilateur (126), dans lequel un axe de rotation (140) du ventilateur centrifuge (124) est décalé par rapport à un point central géométrique (130) du boîtier de ventilateur rectangulaire (126), dans lequel ledit décalage du ventilateur centrifuge (124) à l'intérieur du boîtier de ventilateur rectangulaire (126) est optimisé de sorte qu'une zone haute pression (162) entre une première paroi (198) et une circonférence extérieure (188) du ventilateur centrifuge (124) disposée à une première distance (196) de ladite première paroi (198) du boîtier de ventilateur rectangulaire (126) soit plus grande qu'une zone basse pression (164) entre une deuxième paroi (202) et la circonférence extérieure (188) du ventilateur centrifuge (124) disposée à une deuxième distance (200) de ladite deuxième paroi (202) du boîtier de ventilateur rectangulaire (126), dans lequel la première paroi (198) est opposée à la deuxième paroi (202) et dans lequel un rapport de la première distance (196) sur la deuxième distance (200) est compris entre 2,50 et 1,50.

2. Système d'équipement électrique (120) de la revendication 1, dans lequel le composant d'équipement électrique (122) est un entraînement de moteur (100).

3. Système d'équipement électrique (120) de la revendication 2, dans lequel l'entraînement de moteur (100) comprend un ensemble de circuits de régénération de puissance.

4. Système d'équipement électrique (120) de l'une quelconque des revendications 1 à 3, dans lequel le boîtier de ventilateur rectangulaire (126) comprend un boîtier de ventilateur carré (126), ou
dans lequel le boîtier de ventilateur rectangulaire (126) comprend un ou plusieurs côtés en tôle (222).

5. Système d'équipement électrique (120) de l'une quelconque des revendications 1 à 4, dans lequel le boîtier de ventilateur rectangulaire (126) et le ventilateur centrifuge (124) sont configurés pour recevoir un flux d'air d'entrée (154), et le ventilateur centrifuge (124) est configuré pour générer un flux d'air de sortie (150),
dans lequel le flux d'air de sortie (150) sort du boîtier de ventilateur rectangulaire (126) à un angle de 90 degrés par rapport au flux d'air d'entrée (154).

6. Système d'équipement électrique (120) de l'une quelconque des revendications 1 à 5, dans lequel un rapport de la première distance (196) sur un diamètre (186) du ventilateur centrifuge (124) est compris entre 0,10 et 0,30, ou
dans lequel un rapport de la deuxième distance (200) sur un diamètre (186) du ventilateur centrifuge (124) est compris entre 0,05 et 0,20.

**7.** Système d'équipement électrique (120) de la revendication 1, dans lequel la circonférence extérieure (188) du ventilateur centrifuge (124) est disposée à une première distance (190) d'une paroi de base (192) du boîtier de ventilateur rectangulaire (126), et la circonférence extérieure (188) est disposée à une deuxième distance (194) d'une ouverture supérieure (160) du boîtier de ventilateur rectangulaire (126), dans lequel un flux d'air de sortie (150) généré par le ventilateur centrifuge (124) est configuré pour sortir de l'ouverture supérieure (160), la paroi de base (192) est opposée à l'ouverture supérieure (160), et la première distance (190) et la deuxième distance (194) sont différentes.

**8.** Système d'équipement électrique (120) de la revendication 7, dans lequel un rapport de la première distance (190) sur un diamètre (186) du ventilateur centrifuge (124) est compris entre 0,05 et 0,30.

FIG. 1

FIG. 2

FIG. 3

FIG. 4

FIG. 5

FIG. 6

| GRID | MAX GRID SIZE | SIZE RATIO (>1.3) | MESH COUNT | FLOW COEFFICIENT ($\phi$) |
|---|---|---|---|---|
| COARSE | 0.0412 D | – – – – | 292,242 | 0.06241 |
| MEDIUM | 0.0304 D | 1.36 | 382,133 | 0.06924 |
| FINE | 0.0212 D | 1.43 | 650,734 | 0.06914 |

FIG. 7

FIG. 8

| | ORIGINAL ICEPAK DATA (SPEED = $\omega$) | | CORRECTED ICEPAK DATA (SPEED = $\omega_{MODEL}$) | MANUFACTURER FAN DATA (EQ. 4) |
|---|---|---|---|---|
| POINT | $\phi_{MODEL}$ | $\psi_{MODEL}$ | $\psi_{TUNED}$ | $\psi_{EXP}$ |
| 1 | 0.0973 | 0 | 0 | $f(0.0973 \cdot \omega_{MODEL}/\omega)$ |
| 2 | 0.0790 | 0.032 | $0.032 \cdot (\omega_{MODEL}/\omega)^2$ | $f(0.0790 \cdot \omega_{MODEL}/\omega)$ |
| 3 | 0.0597 | 0.050 | $0.050 \cdot (\omega_{MODEL}/\omega)^2$ | $f(0.0597 \cdot \omega_{MODEL}/\omega)$ |
| 4 | 0.0483 | 0.069 | $0.069 \cdot (\omega_{MODEL}/\omega)^2$ | $f(0.0483 \cdot \omega_{MODEL}/\omega)$ |

FIG. 9

270

FIG. 10

TOP

| $\phi_1$ | $\phi_2$ | $\phi_3$ |
|---|---|---|
| $\phi_4$ | $\phi_5$ | $\phi_6$ |

$\Psi_{BC}$

$\Psi_{BC}$

0.04 D

B

M SIDE

F D R

FRONT

## FIG. 11

280

| VARIABLE | DESCRIPTION | MINIMUM (−1) | MAXIMUM (+1) |
|---|---|---|---|
| F | NORMALIZED DISTANCE FROM IMPELLER TO FRONT WALL | 0.08 D | 0.24 D |
| R | NORMALIZED DISTANCE FROM IMPELLER TO REAR WALL | 0.08 D | 0.24 D |
| B | NORMALIZED DISTANCE FROM IMPELLER TO BACK WALL | 0.08 D | 0.24 D |
| M | NORMALIZED DISTANCE FROM MOTOR HOUSING TO WALL | 0 D | 0.12 D |
| $\Psi_{BC}$ | PRESSURE COEFFICIENT AT OUTLET | 0.032 | 0.069 |

## FIG. 12

20

290

| RUN | M | R | F | $\Psi_{BC}$ | B |
|---|---|---|---|---|---|
| 1 | −1 | −1 | −1 | −1 | +1 |
| 2 | +1 | −1 | −1 | −1 | −1 |
| 3 | −1 | +1 | −1 | −1 | −1 |
| 4 | +1 | +1 | −1 | −1 | +1 |
| 5 | −1 | −1 | +1 | −1 | −1 |
| 6 | +1 | −1 | +1 | −1 | +1 |
| 7 | −1 | +1 | +1 | −1 | +1 |
| 8 | +1 | +1 | +1 | −1 | −1 |
| 9 | −1 | −1 | −1 | +1 | −1 |
| 10 | +1 | −1 | −1 | +1 | +1 |
| 11 | −1 | +1 | −1 | +1 | +1 |
| 12 | +1 | +1 | −1 | +1 | −1 |
| 13 | −1 | −1 | +1 | +1 | +1 |
| 14 | +1 | −1 | +1 | +1 | −1 |
| 15 | −1 | +1 | +1 | +1 | −1 |
| 16 | +1 | +1 | +1 | +1 | +1 |
| 17 | −1 | 0 | 0 | 0 | 0 |
| 18 | +1 | 0 | 0 | 0 | 0 |
| 19 | 0 | −1 | 0 | 0 | 0 |
| 20 | 0 | +1 | 0 | 0 | 0 |
| 21 | 0 | 0 | −1 | 0 | 0 |
| 22 | 0 | 0 | +1 | 0 | 0 |
| 23 | 0 | 0 | 0 | −1 | 0 |
| 24 | 0 | 0 | 0 | +1 | 0 |
| 25 | 0 | 0 | 0 | 0 | −1 |
| 26 | 0 | 0 | 0 | 0 | +1 |
| 27 | 0 | 0 | 0 | 0 | 0 |

FIG. 13

EP 2 645 840 B1

300

| PARAMETER | $\phi_1$ | $\phi_2$ | $\phi_3$ | $\phi_4$ | $\phi_5$ | $\phi_6$ |
|---|---|---|---|---|---|---|
| $a_0$ | 0.021966 | 0.013552 | 0.017679 | 0.10372 | 0.00532 | 0.003527 |
| $a_1$ | 0.061858 | −8.2E−5 | 0.010436 | −0.00405 | −0.00287 | −0.081602 |
| $a_2$ | −0.00573 | 0.009774 | 0.004921 | −0.00339 | 0.000372 | −0.059492 |
| $a_3$ | 0.015917 | 0.007645 | −0.001032 | 0.081508 | −0.01061 | −0.006911 |
| $a_4$ | 0.059867 | −0.1247 | −0.394025 | 0.105791 | −0.03817 | −0.147968 |
| $a_5$ | 0.00274 | 0.025429 | 0.001902 | −0.00307 | −0.00012 | 0.033183 |
| $a_{12}$ | 0.029798 | 0.046725 | 0.030287 | 0.021176 | −0.03533 | 0.710326 |
| $a_{13}$ | − − − − | −0.11753 | 0.121407 | − − − − | 0.041264 | 0.391062 |
| $a_{14}$ | −0.3871 | −0.0686 | −0.631457 | 0.405798 | 0.064687 | 0.075449 |
| $a_{15}$ | 0.033958 | 0.064171 | 0.025348 | −0.01777 | −0.02758 | −0.195815 |
| $a_{23}$ | 0.040751 | − − − − | −0.038468 | 0.0275 | −0.01817 | 0.064855 |
| $a_{24}$ | 0.172243 | −0.22282 | − − − − | − − − − | − − − − | 0.463197 |
| $a_{25}$ | − − − − | −0.026 | −0.006611 | 0.027635 | − − − − | −0.028812 |
| $a_{34}$ | −0.15391 | 0.113632 | 0.104951 | −0.1395 | 0.165848 | 0.101246 |
| $a_{35}$ | 0.143811 | −0.04343 | −0.029511 | − − − − | − − − − | −0.047444 |
| $a_{45}$ | 0.145869 | −0.1683 | 0.130871 | − − − − | − − − − | −0.207214 |
| $a_{11}$ | −0.20957 | − − − − | −0.047465 | − − − − | 0.0878833 | 0.332648 |
| $a_{22}$ | − − − − | − − − − | − − − − | − − − − | −0.0283 | 0.05168 |
| $a_{33}$ | −0.11019 | − − − − | − − − − | −0.10561 | 0.033782 | − − − − |
| $a_{44}$ | 1.94782 | − − − − | 2.082562 | −1.68781 | −0.52113 | 1.727426 |
| $a_{55}$ | −0.08476 | −0.02419 | −0.023697 | − − − − | − − − − | − − − − |
| $a_{112}$ | − − − − | − − − − | − − − − | − − − − | − − − − | −1.090068 |
| $a_{113}$ | − − − − | − − − − | −1.04903 | − − − − | − − − − | −2.686999 |
| $a_{114}$ | − − − − | − − − − | 3.614792 | − − − − | − − − − | − − − − |
| $a_{115}$ | − − − − | − − − − | − − − − | − − − − | − − − − | 1.183033 |
| $a_{221}$ | − − − − | − − − − | − − − − | − − − − | − − − − | −1.422727 |

FIG. 14

310

| VARIABLE | DESIGN 1 | DESIGN 2 |
|---|---|---|
| F | 0.168 D | 0.240 D |
| R | 0.08 D | 0.128 D |
| B | 0.08 D | 0.240 D |
| M | 0 | 0.115 D |
| OBJECTIVE FUNCTION (EQ. 9) | 2.774E-3 | 3.343E-3 |

FIG. 15

FIG. 16

350

FIG. 17

360

FIG. 18

370

FIG. 19

— ICEPAK MODEL (CORRECTED SPEED)    □ DESIGN 2 – SAMPLE 1
-o- DESIGN OF EXPERIMENTS MODEL      ◇ DESIGN 2 – SAMPLE 2
                                      △ DESIGN 2 – SAMPLE 3

380

FIG. 20

— ICEPAK MODEL (CORRECTED SPEED)    □ DESIGN 2 – SAMPLE 1
-o- DESIGN OF EXPERIMENTS MODEL      ◇ DESIGN 2 – SAMPLE 2
                                      △ DESIGN 2 – SAMPLE 3

FIG. 21

FIG. 22

**EP 2 645 840 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2005069410 A1
- WO 2006074447 A2

- US 3561906 A